Europäisches Patentamt

European Patent Office

Office européen des brevets

(11) Veröffentlichungsnummer: **0 352 503**
**A1**

(12) EUROPÄISCHE PATENTANMELDUNG

(21) Anmeldenummer: 89112042.0

(22) Anmeldetag: 01.07.89

(51) Int. Cl.⁴: **G03F 7/031 , G03C 7/12**

(30) Priorität: 20.07.88 DE 3824550

(43) Veröffentlichungstag der Anmeldung:
31.01.90 Patentblatt 90/05

(84) Benannte Vertragsstaaten:
AT BE CH DE ES FR GB IT LI NL SE

(71) Anmelder: BASF Aktiengesellschaft
Carl-Bosch-Strasse 38
D-6700 Ludwigshafen(DE)

(72) Erfinder: Seitz, Friedrich, Dr.
Von-Wieser-Strasse 1
D-6701 Friedelsheim(DE)
Erfinder: Aldag, Reinhard, Dr.
Beckstrasse 23
D-6930 Eberbach(DE)

(54) **Lichtempfindliche, negativ arbeitende Aufzeichnungsschicht.**

(57) Die Erfindung betrifft lichtempfindliche, negativ arbeitende, wäßrig-alkalisch entwickelbare Aufzeichnungsschichten.

Diese bestehen im wesentlichen aus einem Gemisch aus

a) einem oder mehreren in Wasser unlöslichen, in wäßrig-alkalischen Lösungen jedoch löslichen oder zumindest dispergierbaren filmbildenden polymeren Bindemitteln,

b) einer oder mehreren photopolymerisierbaren organischen monomeren Verbindungen mit mindestens einer ethylenisch ungesättigten Doppelbindung oder einem Gemisch derartiger monomerer Verbindungen mit einer oder mehreren, mindestens einfach ethylenisch ungesättigten oligomeren Verbindungen,

c) einem Photoinitiatorsystem bestehend aus

c1) mindestens einer Verbindung mit Thioxanthon-Struktur und

c2) mindestens einer Hexaarylbisimidazol-Verbindung und

c3) mindestens einer mindestens eine Aminogruppe enthaltenden organischen Verbindung und gegebenenfalls

d) üblichen Zusatz- und Hilfsstoffen, wobei die mindestens eine Aminogruppe enthaltende organische Verbindung (c3) bei Wellenlängen zwischen 340 nm und 800 nm einen in Lösung gemessenen Extinktionskoeffizienten von weniger als 5000 l/mol.cm aufweist und außer den in α-Stellung zu dem oder den Stickstoffatomen befindlichen Wasserstoffatomen keinen leicht abstrahierbaren Wasserstoff enthält.

Die erfindungsgemäßen Aufzeichnungsschichten eignen sich insbesondere zur Herstellung von Photoresisten.

EP 0 352 503 A1

## Lichtempfindliche, negativ arbeitende Aufzeichnungsschicht

Die Erfindung betrifft eine lichtempfindliche, negativ arbeitende wäßrigalkalisch entwickelbare Aufzeichnungsschicht mit hoher Ätzbeständigkeit und guter Lagerstabilität.

Die Verwendung von Hexaarylbisimidazol-Verbindungen als Photoinitiatoren in photopolymerisierbaren Aufzeichnungsschichten ist bekannt (vgl. z.B. EP-A 24 629, US-A 3 479 185 und US-A 4 459 349). Wegen der geringen Eigenabsorption der Hexaarylbisimidazol-Verbindungen im aktinischen Bereich ist dazu in den meisten Fällen eine Sensibilisierung der Hexaarylbisimidazol-Verbindungen durch geeignete im aktinischen Bereich absorbierende Substanzen nötig. Als Sensibilisatoren besonders geeignete Substanzen sind beispielsweise p-Aminophenylketone (vgl. z.B. DE-A 1 924 317), bestimmte heterozyklische Stickstoffverbindungen (vgl. z.B. DE-A 37 17 038, DE-A 37 17 036, DE-A 37 17 034 und DE-A 37 17 033) oder auch Thioketone (DE-A 19 52 804). Auch die Kombination von Thioxanthon-Derivaten mit Hexaarylbisimidazol-Verbindungen war aus der US-A 3 926 643 bekannt.

Versucht man jedoch, eine der genannten Kombinationen in photopolymerisierbaren Schichten einzusetzen, die ein oder mehrere in wäßrig-alkalischen Lösungen lösliche oder zumindest dispergierbare Bindemittel enthalten, so stellt man fest, daß die Photopolymerisation so stark verlangsamt wird, daß die erhaltenen Schichten für praktische Anwendungen völlig ungeeignet sind. Andererseits werden mit den Initiatorsystemen, die in wäßrig-alkalisch entwickelbaren Photoresistfilmen eingesetzt werden können, wie z.B. p-Aminophenylketone/Benzophenon oder Thioxanthon-Derivate/-Amine, Resistfilme erhalten, die nur eine geringe Ätzbeständigkeit aufweisen. Auch nimmt die Lichtempfindlichkeit solcher Resiste bei Lagerung häufig ab.

Aufgabe der vorliegenden Erfindung war es daher, ein für wäßrig-alkalisch entwickelbare Photoresistfilme verwendbares Initiatorsystem zu finden, das Resiste mit hoher Ätzbeständigkeit ergibt. Außerdem sollte die Lichtempfindlichkeit der mit diesem Initiatorsystem hergestellten Photoresistfilme auch bei längerer Lagerung konstant bleiben.

Überraschenderweise läßt sich diese Aufgabe in besonders vorteilhafter Weise dadurch lösen, daß man eine Kombination aus einer Verbindung mit Thioxanthon-Struktur, einem Hexaarylbisimidazol-Derivat und bestimmten organischen Verbindungen mit mindestens einer Aminogruppe verwendet. Dabei soll die mindestens eine Aminogruppe enthaltende organische Verbindung im sichtbaren und nahen UV-Bereich des elektromagnetischen Spektrums keine starke Eigenabsorption aufweisen, weil anderenfalls die Absorption durch das Thioxanthon-Derivat gestört würde. Es ist ferner zweckmäßig, daß die mindestens eine Aminogruppe enthaltende organische Verbindung außer den in α-Stellung zu dem oder den Stickstoffatomen befindlichen Wasserstoffatomen keinen leicht abstrahierbaren Wasserstoff enthält, wie er z.B. in den sekundären Wasserstoffatomen von Diarylmethan- oder im tertiären Wasserstoffatom von Triarylmethan-Verbindungen vorliegt. Verbindungen mit leicht abstrahierbaren Wasserstoffatomen werden nämlich in wäßrig-alkalisch entwickelbaren Photoresistfilmen während der Lagerung leicht zu den entsprechenden Farbstoffen oxidiert, was zu einem nicht erwünschten Nachdunkeln der Photoresistfilme führt.

Gegenstand der vorliegenden Erfindung ist eine lichtempfindliche, negativ arbeitende, wäßrig-alkalisch entwickelbare Aufzeichnungsschicht, die im wesentlichen besteht aus einem Gemisch aus

a) einem oder mehreren in Wasser unlöslichen, in wäßrig-alkalischen Lösungen jedoch löslichen oder zumindest dispergierbaren filmbildenden polymeren Bindemitteln,

b) einer oder mehreren photopolymerisierbaren organischen monomeren, mindestens einfach ethylenisch ungesättigten Verbindungen oder einem Gemisch derartiger monomerer Verbindungen mit einer oder mehreren, mindestens einfach ethylenisch ungesättigten oligomeren Verbindungen.

c) einem Photoinitiatorsystem, bestehend aus

c1) mindestens einer Verbindung mit Thioxanthon-Struktur und

c2) mindestens einer Hexaarylbisimidazol-Verbindung und

c3) mindestens einer mindestens eine Aminogruppe enthaltenden organischen Verbindung und gegebenenfalls

d) üblichen Zusatz- und Hilfsstoffen, und dadurch gekennzeichnet ist, daß die mindestens eine Aminogruppe enthaltende organische Verbindung (c3) bei Wellenlängen zwischen 340 nm und 800nm einen in Lösung gemessenen Extinktionskoeffizienten von weniger als 5000 l/mol.cm aufweist und außer den in α-Stellung zu dem oder den Stickstoffatomen befindlichen Wasserstoffatomen keinen leicht abstrahierbaren Wasserstoff enthält. Vorzugsweise enthält die Verbindung (c3) kein tertiäres Kohlenstoffatom, das durch mehr als eine aromatische Gruppe substituiert ist.

In einer bevorzugten Ausführungsform wird die Konzentration der mindestens eine Aminogruppe enthaltenden organischen Verbindung so gewählt, daß, bezogen auf die gesamte Schichtdicke der jeweili-

2

gen photopolymerisierbaren Schicht, weniger als 20% des einfallenden Lichts durch die mindestens eine Aminogruppe enthaltende Verbindung (c3) absorbiert wird.

Bevorzugte aminogruppenhaltige Verbindungen (c3) sind Dialkylaminobenzaldehyd-Verbindungen, Ester der p-Dialkylaminobenzoesäure und Hydroxyalkylamine, wie Mono-, Di und Trialkanolamine. Besonders bevorzugte Amine sind Triethanolamin, Ethanolamin, Diethanolamin, N-Methyldiethanolamin und ähnliche Alkoxyalkylamine. Die mindestens eine Aminogruppe enthaltende Verbindung wird bevorzugt in einer Konzentration von 1 - 10%, besonders bevorzugt in einer Konzentration von 1 - 5%, bezogen auf das Gesamtgewicht der lichtempfindlichen Aufzeichnungsschicht, eingesetzt.

Bevorzugte Hexaarylbisimidazol-Verbindungen (c2) sind die, die z.B. in US-A 3 784 557 oder in EP-A 24 629 beschrieben sind. Besonders bevorzugte Hexaarylbisimidazol-Verbindungen sind 2,2′-Bis(o-chlorphenyl)-4,4′,5,5′-tetraphenylbisimidazolyl und 2,2′-Bis-(o-chlorphenyl)-4,4′,5,5′-tetra(p-methoxyphenyl)-bisimidazolyl. Die Hexaarylbisimidazol-Verbindungen werden bevorzugt in einer Konzentration von 0,5 - 10%, besonders bevorzugt in einer Konzentration von 0,8 - 5%, eingesetzt.

Als Verbindungen mit Thioxanthon-Struktur kommen im allgemeinen Thioxanthon und dessen Derivate, d.h. Thioxanthone mit einem oder zwei Substituenten in Betracht. Bevorzugte Verbindungen mit Thioxanthon-Struktur sind solche Thioxanthone, die einen oder mehrere Alkylsubstituenten tragen, wobei die verschiedenen möglichen Isomeren einzeln oder im Gemisch eingesetzt werden können. Beispiele für besonders geeignete Thioxanthonderivate sind Methylthioxanthon, Isopropylthioxanthon und Diethylthioxanthon. Die Verbindungen mit Thioxanthon-Struktur werden bevorzugt in einer Konzentration, bezogen auf das Gesamtgewicht der lichtempfindlichen Aufzeichnungsschicht, von 0,05 - 5% eingesetzt. In einer besonders bevorzugten Ausführungsform beträgt ihre Konzentration 0,2 - 2%.

Zusätzlich können die erfindungsgemäßen lichtempfindlichen Aufzeichnungsschichten eine farblose oder praktisch farblose organische Verbindung enthalten, die zu einer farbigen Verbindung oxidierbar ist. Diese farbbilden de, zunächst farblose oder praktisch farblose organische Verbindung wird im folgenden als Farbbildner bezeichnet. Als Farbbildner kommen insbesondere Leukofarbstoffe in Betracht, wobei unter Leukofarbstoff die reduzierte Form eines Farbstoffes verstanden wird, die im allgemeinen 1 oder 2 Wasserstoffatome aufweist, deren Entfernung gemeinsam mit 1 oder 2 Elektronen zur Erzeugung des Farbstoffes führt. Diese Leukofarbstoffe sind im wesentlichen farblos oder weisen allenfalls eine geringe, wenig intensive Färbung auf, die von der Farbe des eigentlichen Farbstoffes (oxidierte Form) deutlich verschieden ist. Geeignete Farbstoffe sind insbesondere die Diarylmethan- und Triarylmethan-Farbstoffe in ihrer Leukoform bzw. Farbstoffe mit einer Triarylmethan-Grundstruktur, bei denen zwei der Arylreste über ein N-, S- oder O-Atom miteinander verknüpft sind. Hierzu gehören unter anderem die Leukoform der Aminoacridin-Farbstoffe, der Aminoxanthen-Farbstoffe und der Aminothioxanthen-Farbstoffe. Ferner können als Farbbildner auch Leukomethine eingesetzt werden. Leukofarbstoffe, die als Farbbildner für die erfindungsgemäßen photopolymerisierbaren Aufzeichnungsmaterialien geeignet sind, sind beispielsweise in der US-A 3 552 973 beschrieben. Von besonderem Interesse sind dabei die Leukotriarylmethanfarbstoffe, wie z.B. Leukokristallviolett, Leukomalachitgrün, Leukobasischblau, Leukopararosanilin, Leukopatentblau A oder V.

Es ist dem Fachmann bekannt, daß Leukofarbstoffe in wäßrig-alkalisch entwickelbaren photopolymerisierbaren Schichten bei längerer Lagerung leicht oxidiert werden und dann zu einem Nachdunkeln führen. Die gebildeten Farbstoffe greifen oft inhibierend in den Photopolymerisationsprozeß ein. Man wird daher bei der Verwendung von Leukofarbstoffen versuchen, ihre Konzentration so gering wie möglich zu halten. Die Konzentration des verwendeten Leukofarbstoffs wird in der Regel kleiner als 1%, meist kleiner als 0,7%, jeweils bezogen auf das Gesamtgewicht der photopolymerisierbaren Schicht, sein. Besonders bevorzugt werden solche Leukofarbstoffe eingesetzt, die nur eine geringe Oxidationsneigung aufweisen. Beispiele für solche Leukofarbstoffe sind in der deutschen Patentanmeldung P (O.Z. 0050/40059) genannt. Geeignet sind ebenfalls Leukofarbstoffe des Triarylmethan-Typs, bei denen ein Dialkyl- bzw. Alkylaryl-aminophenylrest durch eine N-Alkyl-substituierte Carbazolylgruppe ersetzt ist, ferner Leukomalachitgrün.

Zu den anderen Komponenten des erfindungsgemäß einzusetzenden Gemisches ist im einzelnen folgendes auszuführen.

a) Als in Wasser unlösliche, in wäßrig-alkalischen Lösungen jedoch lösliche oder zumindest dispergierbare polymere Bindemittel kommen carboxylgruppenhaltige oder Carbonsäureanhydrid-Gruppen enthaltende Co polymerisate in Betracht, wie z.B. Styrol/Maleinsäureanhydrid-Copolymerisate, Styrol/Maleinsäurehalbester-Copolymerisate, Alkyl(meth)acrylat/(Meth)acrylsäure-Copolymerisate, Copolymerisate aus Styrol, Alkyl(meth)acrylaten und (Meth)acrylsäure sowie gegebenenfalls anderen Monomeren (vgl.u.a. DE-B-20 27 467, DE-A-22 05 146, EP-A-49 504 oder DE-A-27 36 058) oder Copolymerisate, die Acrylsäure und/oder Methacrylsäure, hydrophobe Comonomere und N-Vinylamide einpolymerisiert enthalten, wie sie beispielsweise in DE-A-34 47 356 beschrieben sind. Derartige Copolymerisate können

3

beispielsweise 10 bis 50 Gew.% eines Vinylamids, wie z.B. N-Vinylformamid, N-Vinylacetamid, N-Vinyl-N-Methylacetamid oder N-Vinyllactame, wie N-Vinylpyrrolidon und/oder N-Vinylcaprolactam, 5 bis 30 Gew.% Acrylsäure und/oder Methacrylsäure sowie 30 bis 80 Gew.% mindestens eines hydrophoben Comonomeren, welches als solches in Wasser und wäßrig-alkalischen Lösungen unlösliche Homopolymerisate bildet, einpolymerisiert enthalten.

Als Beispiele für die letztgenannten hydrophoben Comonomeren seien genannt: Vinylaromaten, wie z.B. Styrol, substituierte Styrole, die in der Seitenkette oder im Kern beispielsweise durch Alkylgruppen oder Halogenatome substituiert sind, wie α-Methylstyrol, p-Methylstyrol und dergleichen, Vinylacetat sowie die Ester der Acrylsäure und Methacrylsäure, insbesondere die Acrylate und Methacrylate von geradkettigen oder verzweigten Monoalkanolen, vorzugsweise mit 1 bis 4 C-Atomen, wobei hierunter unter anderem das Methylmethacrylat besonders günstig ist. Das Copolymerisat kann ein oder mehrere der hydrophoben Comonomeren einpolymerisiert enthalten, wobei der Anteil der hydrophoben Comonomer-Einheiten in dem Copolymerisat 30 bis 80 Gew.%, vorzugsweise 40 bis 70 Gew.%, bezogen auf das Copolymerisat, betragen kann.

Beispiele für Copolymerisate für den Einsatz als polymeres Bindemittel in den lichtempfindlichen Aufzeichnungsschichten sind u.a. N-Vinyllactam/(Meth)acrylsäure/Methylmethacrylat-Copolymerisate oder N-Vinyllactam/(Meth)acrylsäure/Styrol-Copolymerisate. In einer typischen Ausführungsform können diese Copolymerisate die Comonomeren beispielsweise in Mengen von 25 bis 35 Gew.% an N-Vinylcaprolactam und/oder N-Vinylpyrrolidon, 5 bis 15 Gew.% an (Meth)acrylsäure und 55 bis 65 Gew.% an den hydrophoben Comonomeren, jeweils bezogen auf das Copolymerisat, einpolymerisiert enthalten.

Beispiele für weitere geeignete polymere Bindemittel (a) sind Styrol-(Meth)acrylsäure/Methylmethacrylat/Ethylacrylat-Copolymerisate, die z.B. 10 bis 40 % Styrol, 20 bis 30 % Methacrylsäure, 5 bis 50 % Methylmethacrylat und 0 bis 50 % Ethylacrylat einpolymerisiert enthalten.

Die Comonomeren für die einzusetzenden Copolymerisate (a) werden nach Art und Menge in dem vorstehend angegebenen allgemeinen Rahmen so ausgewählt, daß die Copolymerisate filmbildend sind und die an sie gestellten Forderungen bezüglich ihrer Löslichkeit bzw. Dispergierbarkeit erfüllen. Gegebenenfalls können auch Gemische geeigneter carboxylgruppenhaltiger Copolymerisate eingesetzt werden.

Die als polymeres Bindemittel einzusetzenden Copolymerisate können nach den an sich bekannten und üblichen Polymerisationsmethoden durch Copolymerisation der Comonomeren, beispielsweise in Lösung, hergestellt werden. Für die Lösungspolymerisation eignen sich z.B. niedere Alkanole, Ketone, Ester und ähnliche, wie Methanol, Aceton, Methylethylketon, Ethylacetat etc., als Lösungsmittel. Als Polymerisationsinitiatoren kommen die üblichen radikalischen Starter, wie beispielsweise Azobisisobutyronitril, Benzoylperoxid und dergleichen in Betracht.

Das polymere Bindemittel (a) ist in der lichtempfindlichen Aufzeichnungsschicht im allgemeinen in einer Menge von 1 bis 90 %, vorzugsweise 20 bis 70 Gew.%, bezogen auf das Gesamtgewicht der Aufzeichnungsschicht enthalten.

b) Als photopolymerisierbare organische monomere, mindestens einfach ethylenisch ungesättigten Verbindungen kommen die üblichen ethylenisch ungesättigten photopolymerisierbaren Monomeren in Betracht, vorzugsweise solche mit Siedepunkten über 100° C und Molekulargewichten < 1000. Diese Monomeren können teilweise durch eine oder mehrere oligomere Verbindungen mit mindestens einer ethylenisch ungesättigten Doppelbindung ersetzt sein, wobei die Molekulargewichte dieser Oligomeren im allgemeinen im Bereich zwischen 1000 und 10.000, vorzugsweise zwischen 1500 und 6000 liegen können.

Die photopolymerisierbaren Monomeren und Oligomeren können dabei sowohl mono- als auch polyfunktionell sein, d.h. eine oder mehrere photopolymerisierbare, ethylenische Doppelbindungen besitzen. Üblicherweise sind in der photopolymerisierbaren Aufzeichnungsschicht bi-oder mehrfunktionelle ethylenisch ungesättigte, photopolymerisierbare Verbindungen allein oder Mischungen hiervon mit einem untergeordneten Anteil an monofunktionellen ethylenisch ungesättigten, photopolymerisierbaren Verbindungen enthalten.

Als Vertreter für die photopolymerisierbaren Monomeren seien insbesondere die Derivate der (Meth)acrylsäure und ganz besonders die (Meth)acrylsäureester genannt. Beispiele hierfür sind die Di- und Tri-(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Polypropylenglykolen mit einem Molekulargewicht bis etwa 500, 1,4-Butandiol, 1,1,1-Trimethylolpropan, 2,2-Dimethylpropandiol, Glycerin oder Pentaerythrit; Pentaerythrittetra(meth)acrylat, Glucosetri- oder tetra-(meth)acrylat, ferner die Monoacrylate und Monomethacrylate der genannten Diole und Polyole, wie z.B. Ethylenglykol-, Di-, Tri- oder Tetraethylenglykolmono(meth)acrylat, Propandiol-mono(meth)acrylat und Butandiol-mono(meth)acrylat und die (Meth)acrylate von Monoalkanolen, insbesondere von solchen mit 1 bis 20 C-Atomen. Neben den bevorzugten Acrylaten und Methacrylaten der vorstehend genannten Art seien als photopolymerisierbare

EP 0 352 503 A1

Monomere auch die Allyl-Verbindungen und andere Vinyl-Verbindungen genannt, wie z.B. N-Vinylpyrrolidon, N-Vinylcaprolactam, Vinylacetat, Vinylpropionat, (Meth)acrylamid, N-Methylol-(meth)acrylamid, der Bisether des Ethylenglykols und N-Methylol-(meth)acrylamids, Vinylcarbamate, Bisacrylamidoessigsäure, Glyoxalbisamid und andere.

Geeignete ethylenisch ungesättigte, photopolymerisierbare Verbindungen für die erfindungsgemäßen lichtempfindlichen Aufzeichnungsschichten sind auch die monomeren Urethanacrylate bzw. -methacrylate mit zwei oder mehr Acryloyl- und/oder Methacrylol-Gruppen. Solche monomeren Urethan(meth)acrylate können beispielsweise erhalten werden durch Umsetzung von aliphatischen Di- oder Polyolen mit organischen Diisocyanaten in einem Äquivalentverhältnis OH:NCO von etwa 1:2 und anschließende Umsetzung der freien Isocyanatgruppen des erhaltenen Reaktionsproduktes mit geeigneten Acryloyl- und/oder Methacryloyl-Verbindungen, beispielsweise Hydroxyalkyl-(meth)acrylaten. Als aliphatische Di- oder Polyole kommen unter anderem die vorstehend im Zusammenhang mit den Di- und Tri(meth)acrylaten genannten Di- und Polyhydroxy-Verbindungen in Betracht; als Beispiele für organische Diisocyanate seien Hexamethylendiisocyanat, Toluylendiisocyanat, Isophorondiisocyanat und ähnliche genannt; Hydroxyalkyl(meth)acrylate sind beispielsweise Hydroxyethyl-(meth)acrylat, Propandiol-mono(meth)acrylat oder Butandiol-mono(meth)-acrylat. Ebenso geeignet und vorteilhaft sind Monomere mit zwei oder mehr Acryloyl- und/oder Methacryloyl-Gruppen, wie sie beispielsweise erhalten werden können durch Umsetzung von Di- oder Polyglycidylverbindungen mit Acrylsäure und/oder Methacrylsäure. Als Di- und Polyglycidylverbindungen kommen hier insbesondere die Di- und Polyglycidylether mehrwertiger Phenole, beispielsweise des Bisphenols A oder der Substitutionsprodukte von Bisphenol A, in Betracht. Beispielhaft für solche Acryloyl- und/oder Methacryloyl-Gruppen enthaltenden Monomeren seien die Umsetzungsprodukte des Bisphenol A-bisglycidylethers mit Acryl- und/oder Methacrylsäure im molaren Verhältnis von etwa 1:2 hervorgehoben.

Als vorteilhaft für die Herstellung von Resistmustern hat es sich erwiesen, wenn die lichtempfindlichen Aufzeichnungsschichten als photopolymerisierbare Verbindung Oligomere mit 2 oder vorzugsweise mehr als 2 Acryloyl- und/oder Methacryloyl-Gruppen enthalten. Hierbei kann es sich beispielsweise um Acryloyl- und/oder Methacryloyl-Gruppen enthaltende oligomere Urethan-Harze oder um solche auf Basis von Di- oder Polyepoxiden handeln, wie sie als solche bekannt und in der Literatur beschrieben sind, wie z.B. solche Oligomeren die neben den Acryloyl-und/oder Methacryloyl-Gruppen zusätzlich noch freie Carboxylgruppen im Molekül enthalten. Die Oligomeren können so Säurezahlen im Bereich von 50 bis 150 mg KOH/g aufweisen. Geeignete photopolymerisierbare Oligomere dieser Art sind z.B. in der DE-A-24 42 527, der DE-C-25 57 408 odr auch der DE-A-29 17 483 beschrieben. Weitere photopolymerisierbare Oligomere können beispielsweise hergestellt werden, indem man die Hydroxylgruppen einer Acryloyl- und/oder Methacryloyl-Gruppen enthaltenden Diol- oder Polyol-Verbindung derart mit mehrfachen Carbonsäuren oder deren Derivaten, insbesondere cyclischen Carbonsäureanhydriden, umsetzt, daß sich die sauren Teilester der mehrfachen Carbonsäuren bilden, und anschließend einen Teil der freien Carboxylgruppen des so erhaltenen Reaktionsprodukts unter Kettenverlängerung sowie gegebenenfalls Verzweigung mit Di- und/oder Polyepoxiden umsetzt. Die Acryloyl-und/oder Methacryloyl-Gruppen enthaltenden Diol- oder Polyol-Verbindungen, die als Ausgangsprodukt für die Herstellung solcher Oligomeren dienen, werden zweckmäßigerweise hergestellt, indem man Di- oder Polyepoxid-Verbindungen, wie z.B. Di- oder Polyglycidylether bzw. Di- oder Polyglycidylester mit Acrylsäure und/oder Methaycrylsäure im Äquivalentverhältnis Glycidyl-Gruppen:COOH-Gruppen von etwa 1:1 umsetzt. Die Di- oder Polyepoxid-Verbindungen können dabei auch beispielsweise vor oder während der Umsetzung mit der (Meth)acrylsäure durch Umsetzung mit Dicarbonsäuren vorverlängert werden. Beispielhaft und stellvertretend für Oligomere der letztgenannten Art seien die Produkte genannt, wie sie erhältlich sind durch Umsetzung von Bisphenol A-bisglycidylether mit Acryl- und/oder Methacrylsäure bzw. mit einem Gemisch aus etwa 30 bis 70 Mol.% einer Dicarbonsäure, beispielsweise·Adipinsäure, und etwa 30 bis 70 Mol.% Acryl- und/oder Methacrylsäure im Äquivalentverhältnis Glycidyl-Gruppen:Gesamt-COOH von etwa 1:1, Umsetzung der Hydroxyl-Gruppen des so erhaltenen Reaktionsproduktes mit einem cyclischen Dicarbonsäureanhydrid, beispielsweise Phthalsäureanhydrid, gegebenenfalls in Mischung mit einem untergeordneten Anteil des Anhydrids einer anderen mehrfachen Carbonsäure, z.B. Trimellithsäureanhydrid, im Äquivalentverhältnis OH-Gruppen:Anhydrid-Gruppen von etwa 1:1 unter Bildung der sauren Teilester der mehrfachen Carbonsäuren und schließlich Umsetzung eines Teils der freien Carboxyl-Gruppen des so erhaltenen Reaktionsproduktes mit einem Di- und/oder Polyglycidylether, beispielsweise Bisphenol A-bisglycidylether oder Pentaerythrittriglycidylether, im Äquivalentverhältnis COOH-Gruppen:Glycidyl-Gruppen von größer 1:1, vorzugsweise im Bereich von etwa 1,15:1 bis 5:1. Derartige Oligomere sind beispielsweise in DE-A 34 47 355 beschrieben.

Die ethylenisch ungesättigten, photopolymerisierbaren Monomeren und deren Gemische mit Oligomeren werden dabei - für den Fachmann selbstverständlich - so gewählt, daß sie mit den als polymerem Bindemittel (a) eingesetzten Copolymerisaten verträglich sind. Das Mengenverhältnis von polymerem

5

Bindemittel (a) zu den ethylenisch ungesättigten, photopolymerisierbaren Verbindungen (b) in der lichtempfindlichen Aufzeichnungsschicht kann in weiten Grenzen variiert werden und beispielsweise im Bereich von 1:99 bis 90:10 liegen. Ein niedriger Anteil an polymerem Bindemittel, beispielsweise im Bereich von etwa 1 bis 35 Gew.%, bezogen auf die photopolymerisierbare Aufzeichnungsschicht, kommt insbesondere dann in Betracht, wenn in der photopolymerisierbaren Aufzeichnungsschicht als ethylenisch ungesättigte, photopolymerisierbare Verbindung ein hoher Anteil, beispielsweise 40 Gew.% oder mehr und insbesondere mehr als etwa 45 Gew.%, bezogen auf die photopolymerisierbare Aufzeichnungsschicht, an einem oder mehreren, mehr als zwei Acryloyl- und/oder Methacryloyl-Gruppen sowie freie Carboxyl-Gruppen enthaltenden Oligomeren enthalten ist.

c) Als weitere Zusatz- und/oder Hilfsstoffe (d), die in der erfindungsgemäßen lichtempfindlichen Aufzeichnungsschicht enthalten sein können, kommen z.B. thermische Polymerisationsinhibitoren, Farbstoffe und/oder Pigmente, sensitometrische Regler, Weichmacher, Verlaufshilfsmittel, Mattierungs- oder Gleitmittel und dergleichen in Betracht. Geeignete thermische Polymerisationsinhibitoren sind z.B. Hydrochinon, Hydrochinon-Derivate, 2,6-Di-t.-butyl-p-cresol, Nitrophenole, N-Nitrosoamine, wie N-Nitrosodiphenylamin oder die Salze des N-Nitrosocyclohexylhydroxylamins. Beispiele für Farbstoffe und/oder Pigmente, die sowohl als Kontrastmittel als auch schichtverfestigend wirken können, sind u.a. Brilliant Green Dye (C.I. 42 040), Viktoria-Reinblau FGA, Viktoria-Reinblau BO (C.I. 42 595), Viktoria-Blau B (C.I. 44 045), Rhodamin 6 G (C.I. 45 160), Triphenylmethanfarbstoffe, Naphthalimidfarbstoffe, Azosole und 3′-Phenyl-7-dimethylamino-2,2′-spiro-di-(2H-1-benzopyran). Zu den sensitometrischen Reglern gehören Verbindungen wie z.B. 9-Nitroanthracen, 10,10′-Bisanthron, Phenazinium-, Phenoxazinium-, Acridinium- oder Phenothiazinium-Farbstoffe, insbesondere in Kombination mit milden Reduktionsmitteln, 1,3-Dinitrobenzole und ähnliche. Als Weichmacher können die an sich bekannten und üblichen niedermolekularen oder hochmolekularen Ester, wie Phthalate oder Adipate, Toluolsulfonamid oder Tricresylphosphat, dienen. Die Zusatz- und/oder Hilfsstoffe sind in den photopolymerisierbaren Aufzeichnungsschichten in den für diese Stoffe üblichen und bekannten wirksamen Mengen vorhanden. Ihre Menge sollte jedoch im allgemeinen 30 Gew.%, vorzugsweise 20 Gew.%, bezogen auf die lichtempfindliche Aufzeichnungsschicht, nicht überschreiten.

Das Mischungsverhältnis, in dem die einzelnen Komponenten in der lichtempfindlichen Aufzeichnungsschicht enthalten sind, wird im allgemeinen so gewählt, daß diese Aufzeichnungsschicht nicht nur wäßrig-alkalisch entwickelbar, sondern vorteilhafterweise auch bei Raumtemperatur fest und nicht klebrig ist und gute Filmbildungseigenschaften besitzt. Für den Einsatz der erfindungsgemäßen lichtempfindlichen Aufzeichnungselemente als Photoresistfilm wird die Zusammensetzung darüber hinaus so gewählt, daß die lichtempfindliche Aufzeichnungsschicht gut laminierbar und unter Anwendung von Druck sowie gegebenenfalls Wärme auf ein Substrat übertragbar ist. Für die Herstellung von Resistmustern werden üblicherweise Schichtdicken der lichtempfindlichen Aufzeichnungsschicht im Bereich von etwa 1 bis 100 µm eingestellt.

Besondere Vorteile der erfindungsgemäßen Aufzeichnungsschichten sind die hohe Beständigkeit gegenüber allen bei der Fertigung gedruckter Schaltungen verwendeten Ätzlösungen. Sie zeichnen sich ferner dadurch aus, daß selbst bei längerer Lagerung und bei erhöhter Temperatur und Luftfeuchtigkeit kein Rückgang der Lichtempfindlichkeit zu verzeichnen ist.

Die Erfindung wird durch die nachfolgenden Beispiele näher erläutert. Die in den Beispielen genannten Teile und Prozente beziehen sich, sofern nicht anders angegeben, auf das Gewicht.

Die Vergleichsbeispiele 1 und 2 zeigen, daß Hexaarylbisimidazol-Verbindungen auch in Kombination mit geeigneten Sensibilisatoren in wäßrig alkalisch entwickelbaren photopolymerisierbaren Schichten keine oder nur eine geringe polymerisationsinitiierende Wirkung aufweisen.

Vergleichsbeispiel 1

Eine Stammlösung zur Herstellung eines Photoresistfilms wurde durch Mischen der folgenden Komponenten hergestellt:

6

| 1) | 50%ige Lösung (in Essigester) eines Oligomeren ( = Umsetzungsprodukt aus Bisphenol A-diglycidylether (5 Teile), Adipinsäure (1 Teil) und Phthalsäureanhydrid (2,5 Teile) | 80,00 g |
|---|---|---|
| 2) | 28%ige Lösung (in Aceton) eines Copolymeren aus Methylmethacrylat (60%), N-Vinylpyrrolidon (30%) und Methacrylsäure (10%) mit einem K-Wert nach Fikentscher von 40 | 107,00 g |
| 3) | Butandioldiacrylat | 11,00 g |
| 4) | Trimethylolpropantriacrylat | 12,00 g |
| 5) | Sicometpatentblau 80E131 (CI 42 051) | 0,05 g |

Zu dieser Stammlösung wurden als Photoinitiatorsystem die folgenden Komponenten gegeben:

| a) | Isopropylthioxanthon | 0.50 g |
|---|---|---|
| b) | 2,2'-Bis(o-chlorphenyl)-4,4',5,5'-tetraphenylbisimidazolyl | 3.00 g |

Die filtrierte Lösung wurde so auf eine 23 $\mu$m dicke Polyesterfolie gegossen, daß nach dem Ablüften des Lösungsmittels und Trocknen (3 min bei 80 °C) eine Trockenschichtdicke von 35 $\mu$m resultierte. Die so hergestellte photopolymerisierbare Resistschicht wurde bis zur Weiterverarbeitung dieses Photoresistfilms mit einer Polyethylenfolie abgedeckt. Zur Prüfung wurde die Polyethylenfolie entfernt, der Photoresist bei 80 °C bis 120 °C auf ein kupferkaschiertes Leiterplattensubstrat auflaminiert und in einem Riston-PC-Printer bildmäßig mit aktinischem Licht durch einen Graukeil belichtet, dessen aufeinanderfolgende Stufen sich in ihrer optischen Dichte jeweils um $\frac{4}{\sqrt{2}}$ unterschieden. Nach der Belichtung wurde die Polyesterfolie entfernt und der Photoresist bei 30 °C mit einer 1%igen wäßrigen Sodalösung entwickelt. Nach Bestrahlung mit 400 mJ/cm² und Entwicklung wurde auf dem Graukeil lediglich Stufe 10 erreicht. Die erzielte Lichtempfindlichkeit ist also für praktische Anwendungen viel zu gering.

Vergleichsbeispiel 2

Zu der in Vergleichsbeispiel 1 beschriebenen Stammlösung wurden die folgenden Komponenten gegeben:

| a) | Michler's Keton | 0,15 g |
|---|---|---|
| b) | 2,2'-Bis(o-chlorphenyl)-4,4',5,5'-tetraphenylbisimidazolyl | 3,00 g |
| c) | Kristallviolett-Leukobase | 0,60 g |

Aus der erhaltenen Lösung wurde wie in Vergleichsbeispiel 1 beschrieben ein Photoresistfilm hergestellt. Die Prüfung der Lichtempfindlichkeit ergab, daß 250 mJ/cm² erforderlich waren, um auf dem angegebenen Graukeil Stufe 8 zu erreichen, d.h. die erzielbare Lichtempfindlichkeit ist für alle praktischen Anwendungen zu gering.

In Beispiel 1 wird gezeigt, daß der Zusatz eines erfindungsgemäß einzusetzenden Amins zum in Vergleichsbeispiel 1 gezeigten Initiatorsystem eine dramatische Erhöhung der Lichtempfindlichkeit bewirkt.

Beispiel 1

Zu der in Vergleichsbeispiel 1 genannten Stammlösung wurden folgende Komponenten gegeben:

| a) | Isopropylthioxanthon | 0,50 g |
|---|---|---|
| b) | 2,2'-Bis(o-chlorphenyl)-4,4',5,5'-tetraphenylbisimidazolyl | 3,00 g |
| c) | Ethyl-(p-dimethylamino)benzoat | 3,00 g |

Aus dieser Lösung wurde, wie in Vergleichsbeispiel 1 beschrieben, ein Photoresistfilm hergestellt. Die Prüfung der Lichtempfindlichkeit ergab, daß bei einer Belichtung mit 80 mJ/cm² auf dem verwendeten Graukeil Stufe 13 erreicht wurde. Zur Prüfung der Lagerstabilität wurde der Resist eine Woche bei 50°C im Trockenschrank gelagert. Dabei wurde kein Rückgang der Lichtempfindlichkeit beobachtet.

Vergleichsbeispiel 3 zeigt, daß es nicht möglich ist, anstelle des erfindungsgemäßen Amins einen eine Aminogruppe enthaltenden Leukofarbstoff zu verwenden.

Vergleichsbeispiel 3

Zu der in Vergleichsbeispiel 1 beschriebenen Stammlösung wurden die folgenden Komponenten gegeben:

| a) | Isopropylthioxanthon | 0,50 g |
| b) | 2,2'-Bis(o-chlorphenyl)-4,4',5,5'-tetraphenylbisimidazolyl | 3,00 g |
| c) | Kristallviolett-Leukobase | 0,60 g |

Die Lösung wurde entsprechend den vorangegangenen Beispielen zu einem Photoresist gegossen. Mit diesem Rest wurde eine Lichtempfindlichkeit von Stufe 7 bei Belichtung mit 80 mJ/cm*cm erreicht. Um Stufe 13, wie in Beispiel 1 zu erreichen, mußte mit 200 mJ/cm² belichtet werden. Bei der Prüfung der Lagerstabilität analog Beispiel 1 wurde ein Rückgang der Lichtempfindlichkeit um 50% beobachtet. Zudem war der Resistfilm durch Oxidation der Kristallviolett-Leukobase fleckig schwarz verfärbt. Eine Erhöhung der Konzentration der Kristalviolett-Leukobase zur Steigerung der Lichtempfindlichkeit scheidet somit aus, da bereits bei der angegebenen Konzentrationnicht akzeptable Probleme mit der Lagerstabilität auftreten.

Das folgende Beispiel demonstriert die Überlegenheit des erfindungsgemäßen Photoinitiatorsystems gegenüber einem für wäßrig-alkalisch entwickelbare Photoresiste herkommlichen System.

Beispiel 2 und Vergleichsbeispiel 4

Eine Gießlösung zur Herstellung eines Photoresistfilms wurde durch Mischen der folgenden Komponenten hergestellt:

| 1) | 37%ige Lösung (in Methylethylketon/Isopropanol 1/1) eines Copolymeren aus Styrol (23%), Methylmethacrylat (35%), Butylacrylat (11%) und Methacrylsäure (30%) mit einem K-Wert nach Fikentscher von 42 | 149,80 g |
| 2) | Trimethylolpropantriacrylat | 38,00 g |
| 3) | Sicometpatentblau 80E131 | 0,05 g |
| 4) | Isopropylthioxanthon | 0,50 g |
| 5) | Ethyl-(p-dimethylamino)benzoat | 3,00 g |

Die erhaltene Lösung wurde in zwei gleiche Teile geteilt, von denen der als Vergleich dienende wie oben beschrieben zu einem Photoresistfilm vergossen wurde (Vergleichsbeispiel 4). Zur anderen Hälfte wurden 0,50 g 2,2'-Bis(o-chlorphenyl)-4,4',5,5'-tetraphenylbisimidazolyl gegeben. Diese Lösung wurde nach gründlichem Mischen ebenfalls zu einem Photoresistfilm vergossen (Beispiel 2).

Bei Belichtung mit 50 mJ/cm² wurde mit dem Resist nach Beispiel 2 auf dem verwendeten Graukeil Stufe 13 erreicht, während mit dem Vergleichsbeispiel nur Stufe 10 erreicht wurde. Die Resiste wurden außerdem durch ein Testnegativ belichtet, das feine Linien mit 50 bis 500 μm Breite enthielt. Der Resist gemäß Beispiel 2 wurde mit 50 mJ/cm², der Resist gemäß Vergleichsbeispiel 4 mit 80 mJ/cm*cm belichtet.

Anschließend wurden die unbelichteten Teile des Resists durch Sprühentwicklung mit 1%iger Sodalösung entfernt und die kupferkaschierten Leiterplattensubstrate durch Ätzen in ammoniakalischer Kupferchloridlösung strukturiert. Bei Beispiel 2 waren lediglich die Linien mit einer Breite von 50 μm teilweise abgelöst, während beim Vergleichsbeispiel alle Linien mit einer Breite kleiner als 500 μm abgelöst waren.

Beispiele 3 bis 5

Eine Gießlösung zur Herstellung eines Photoresistfilms wurde durch Mischen der folgenden Komponenten hergestellt:

| | | | |
|---|---|---|---|
| 1) | 39%ige Lösung (in Methylethylketon/Isopropanol 1/1) eines Copolymeren aus Styrol (40%), Methylmethacrylat (10%), Ethylacrylat (25%) und Methacrylsäure (25%) mit einem K-Wert nach Fikentscher von 43,5 | 153,80 g |
| 2) | Trimethylolpropantriacrylat | 25,00 g |
| 3) | Tetraethylenglykoldiacrylat | 15,00 g |
| 4) | 2,2'-Bis(o-chlorphenyl)-4,4',5,5'-tetraphenylbisimidazolyl | 2,00 g |
| 5) | N-Methyldiethanolamin | 3,00 g |
| 6) | Sicometpatentblau 80E131 | 0,05 g |

Die Lösung wurde in drei gleiche Teile geteilt, die mit jeweils 0,30 g Methylthioxanthon (Beispiel 3), Diethylthioxanthon (Beispiel 4) bzw. Isopropylthioxanthon (Beispiel 5) versetzt wurden. Die Lösungen wurden auf die in Vergleichsbeispiel 1 beschriebene Weise zu Filmen gegossen und auf ihre Eignung als Photoresistfilme geprüft. Mit allen Ansätzen wurden hohe Lichtempfindlichkeiten erzielt. Die Stabilität feiner Linien gegenüber alkalischem Ätzen war ebenfalls ausgezeichnet.

| | Lichtempfindlichkeit (60 mJ/cm$^2$ | Ätzstabilität (gehaltene Linienbreite) |
|---|---|---|
| Beispiel 3 | Stufe 12 | 70 μm |
| Beispiel 4 | Stufe 13 | 50 μm |
| Beispiel 5 | Stufe 12 | 50 μm |

Beispiel 6

Eine Gießlösung zur Herstellung eines lichtempfindlichen Aufzeichnungsmaterials wurde durch Mischen der folgenden Komponenten hergestellt:

| | | | |
|---|---|---|---|
| 1) | 39%ige Lösung (in Methylethylketon/Isopropanol 1/1) eines Copolymeren aus Styrol (40%), Methylmethacrylat (10%), Ethylacrylat (25%) und Methacrylsäure (25%) mit einem K-Wert nach Fikentscher von 43,5 | 153,80 g |
| 2) | Trimethylolpropantripropoxytriacrylat | 20,00 g |
| 3) | Tripropylenglykoldiacrylat | 20,00 g |
| 4) | 2,2'-Bis(o-chlorphenyl)-4,4',5,5'-tetra-(p-methoxyphenyl)bisimidazolyl | 1,50 g |
| 5) | N-Methyldiethanolamin | 4,00 g |
| 6) | Methylthioxanthon | 0,80 g |
| 7) | Sicometpatentblau 80E131 | 0,05 g |

Die Lösung wurde auf die beschriebene Weise zu einem Photoresistfilm gegossen. Die Prüfung ergab eine hohe Lichtempfindlichkeit (Stufe 14 bei 60 mJ/cm$^2$) und gute Ätzstabilität (gehaltene Linie: 50 $\mu$m).

Beispiel 7

Eine durch Mischen der folgenden Komponenten hergestellte Gießlösung wurde zu einem Photoresistfilm verarbeitet:

| | | |
|---|---|---|
| 1) | 50%ige Lösung (in Essigester) eines Oligomeren (= Umsetzungsprodukt aus Bisphenol A-diglycidylether (5 Teile), Adipinsäure (1,2 Teile) Acrylsäure (1 Teil) und Phthalsäureanhydrid (2,5 Teile) | 80,00 g |
| 2) | 28%ige Lösung (in Aceton) eines Copolymeren aus Methylmethacrylat (60%), N-Vinylpyrrolidon (30%) und Methacrylsäure (10%) mit einem K-Wert nach Fikentscher von 40 | 107,00 g |
| 3) | Butandioldiacrylat | 8,00 g |
| 4) | Trimethylolpropantriethoxytriacrylat | 15,00 g |
| 5) | N-Methyldiethanolamin | 5,00 g |
| (6) | Isopropylthioxanthon | 1,00 g |
| (7) | 2,2'-Bis(o-chlorphenyl)-4,4',5,5'-tetraphenylbisimidazolyl | 3,00 g |
| (8) | Malachitgrün-Leukobase | 0,50 g |
| (9) | Sicometpatentblau 80E131 | 0,05 g |

Die erhaltenen Resistfilme zeigten hohe Lichtempfindlichkeit (Stufe 12 bei 80 mJ/cm$^2$) bei guter Ätzstabilität (gehaltene Linie: 70 $\mu$m). Sie zeigten ferner einen guten Kontrast des belichteten gegenüber dem unbelichteten Resist. Die Prüfung der Lagerstabilität nach Beispiel 1 ergab, daß kein Rückgang der Lichtempfindlichkeit auftritt.

## Ansprüche

1. Lichtempfindliche, negativ arbeitende, wäßrig-alkalisch entwickelbare Aufzeichnungsschicht, die im wesentlichen besteht aus einem Gemisch aus
a) einem oder mehreren in Wasser unlöslichen, in wäßrig-alkalischen Lösungen jedoch löslichen oder zumindest dispergierbaren filmbildenden polymeren Bindemitteln,
b) einer oder mehreren photopolymerisierbaren organischen monomeren, mindestens einfach ethylenisch ungesättigten Verbindungen oder einem Gemisch derartiger monomerer Verbindungen mit einer oder mehreren, mindestens einfach ethylenisch ungesättigten oligomeren Verbindungen,
c) einem Photoinitiatorsystem bestehend aus
c1) mindestens einer Verbindung mit Thioxanthon-Struktur und
c2) mindestens einer Hexaarylbisimidazol-Verbindung und
c3) mindestens einer mindestens eine Aminogruppe enthaltenden organischen Verbindung und gegebenenfalls
d) üblichen Zusatz- und Hilfsstoffen,
dadurch gekennzeichnet, daß die mindestens eine Aminogruppe enthaltende organische Verbindung (c3) bei Wellenlängen zwischen 340 nm und 800 nm einen in Lösung gemessenen Extinktionskoeffizienten von weniger als 5000 l/mol.cm aufweist und außer den in $\alpha$-Stellung zu dem oder den Stickstoffatomen befindlichen Wasserstoffatomen keinen leicht abstrahierbaren Wasserstoff enthält.
2. Lichtempfindliche Aufzeichnungsschicht nach Anspruch 1, dadurch gekennzeichnet, daß als mindestens eine Aminogruppe enthaltende organische Verbindung (c3) eine solche eingesetzt wird, die kein tertiäres Kohlenstoffatom enthält, das durch mehr als eine aromatische Gruppe substituiert ist.
3. Lichtempfindliche Aufzeichnungsschicht nach Anspruch 1 oder 2, dadurch gekennzeichnet, daß die Konzentration der mindestens eine Aminogruppe enthaltenden organischen Verbindung (c3) so gewählt wird, daß weniger als 20% des einfallenden Lichts von dieser Aminoverbindung absorbiert wird.

4. Lichtempfindliche Aufzeichnungsschicht nach einem der vorhergehenden Ansprüche, dadurch gekennzeichnet, daß als organische Verbindung (c3) eine Verbindung aus der Gruppe der Mono-, Di- oder Trialkanolamine, der Ester der p-Dialkylaminobenzoesäure oder der p-Dialkylaminobenzaldehyde eingesetzt wird.

5. Lichtempfindliche Aufzeichnungsschicht nach einem der vorhergehenden Ansprüche, dadurch gekennzeichnet, daß sie zusätzlich einen Leukofarbstoff enthält.

| | Europäisches Patentamt | EUROPÄISCHER RECHERCHENBERICHT | | Nummer der Anmeldung |
|---|---|---|---|---|
| | | | | EP 89 11 2042 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X,Y | PATENT ABSTRACTS OF JAPAN, Band 11, Nr. 12 (P-535)[2459], 13. Januar 1987; & JP-A-61 188 533 (SEKISUI CHEM. CO. LTD) 22-08-1986 * Zusammenfassung * --- | 1-5 | G 03 F 7/031 |
| Y | GB-A-2 095 248 (NIPPON KAYAKU K.K.) * Seite 3, Zeilen 24-47 * --- | 1-5 | |
| Y | US-A-3 759 807 (C.L. OSBORN et al.) * Beispiele 11-14 * --- | 1-5 | |
| Y,D | US-A-3 926 643 (C.T.-L. CHANG) * Spalte 2, Zeilen 25-44 * --- | 1-5 | |
| Y,D | US-A-4 459 349 (T. TANAKA et al.) * Spalte 2, Zeile 6 - Spalte 3, Zeile 58 * ----- | 1-5 | |
| | | | RECHERCHIERTE SACHGEBIETE (Int. Cl.5) |
| | | | G 03 F 7/031 |

Der vorliegende Recherchenbericht wurde für alle Patentansprüche erstellt

| Recherchenort | Abschlußdatum der Recherche | Prüfer |
|---|---|---|
| DEN HAAG | 02-10-1989 | MARKHAM R. |

EPO FORM 1503 03.82 (P0403)